# EUROPEAN PATENT APPLICATION

(11) **EP 4 697 379 A1**
(43) Date of publication of application: **18.02.2026**
(21) Application number: 24788666.6
(22) Date of filing: 05.04.2024
(51) Int. Cl.: H01L 21/683

(54) **MOUNTER DEVICE, TAPE PEELING DEVICE, SUBSTRATE TRANSFER DEVICE, TAPE PEELING METHOD, AND SUBSTRATE TRANSFER METHOD**

(30) Priority: 12.04.2023 JP 2023064943
(71) Applicant: Teikoku Taping System Co., Ltd., Tokai-shi, Aichi 477-0032 (JP)
(72) Inventor: LEE, Hiromitsu, Tokai-shi, Aichi 477-0032 (JP); KATSUSHIMA, Yoshinori, Tokai-shi, Aichi 477-0032 (JP)
(74) Representative: Epping - Hermann - Fischer
(86) International application number: PCT/JP2024/014045
(87) International publication number: WO 2024/214641

(57) **Abstract**

A substrate transfer apparatus (100) includes a tape removal mechanism (RM) for peeling a first adhesive tape (T1) applied to a wafer (W). The tape removal mechanism (RM)is configured to cause a peeling angle (a) to differ between a time when peeling starts and a time when peeling ends. Specifically, the tape removal mechanism (RM) includes a heat seal (RM5) configured to heat a peeling tape (PT) while pressing the peeling tape (PT) against the first adhesive tape (T1), and a peeling tape collection roller (RM2) configured to collect the peeling tape (PT). The peeling tape (PT) heated by the heat seal (RM5) is welded to the first adhesive tape (T1), and the first adhesive tape (T1) is peeled from the wafer (w) by being pulled by the peeling tape (PT) as the peeling tape (PT) is collected by the peeling tape collection roller (RM2).

## Description

### TECHNICAL FIELD

The present disclosure relates to a mounter device, a tape removal device, a substrate transfer apparatus, a tape removal method, and a substrate transfer method.

### BACKGROUND ART

A device having a mechanism for removing adhesive tapes from semiconductor wafers is known (see Patent Document 1).

### RELATED ART DOCUMENTS

### PATENT DOCUMENT

Patent Document 1: Japanese Patent No. 6695173

### SUMMARY OF THE INVENTION

### PROBLEMS TO BE SOLVED BY THE INVENTION

The above-described mechanism is configured to cause a peeling force to act so as to peel an adhesive tape from a semiconductor wafer by applying a peeling tape to the non-adhesive surface of the adhesive tape applied to the semiconductor wafer and winding a peeling tape along the upper surface (inclined surface) of a knife-edge-shaped removal member, with the lower surface (horizontal surface) of the removal member facing the non-adhesive surface of the adhesive tape.

However, since the above-described mechanism can cause the peeling force to act only in the direction along the upper surface (inclined surface) of the removal member, there is a possibility that an undesired force may be applied to the semiconductor wafer when the adhesive tape is peeled from the semiconductor wafer, and the semiconductor wafer may be damaged.

Therefore, it is desirable to provide a device capable of suppressing damage to a substrate such as a semiconductor wafer when an adhesive tape is peeled from the substrate.

### MEANS FOR SOLVING PROBLEMS

A mounter device according to an embodiment of the present invention is a mounter device for applying an adhesive tape to a ring frame and a substrate, or for separating the ring frame and the substrate, both the ring frame and the substrate being adhered to the adhesive tape, and the mounter device includes a tape removal mechanism configured to peel the adhesive tape applied to the substrate. The tape removal mechanism is configured to cause a peeling angle to differ between a time when peeling starts and a time when peeling ends.

### EFFECTS OF THE INVENTION

The above-described mounter device can suppress damage to the substrate when peeling the adhesive tape from the substrate.

### BRIEF DESCRIPTION OF THE DRAWINGS

FIG. 1 illustrates a configuration example of a substrate transfer apparatus;
FIG. 2 illustrates a configuration example of a mount frame;
FIG. 3 is a front view of the wafer separation mechanism;
FIG. 4 is a front view of a portion of a tape application mechanism;
FIG. 5 is a right-side view of a portion of the tape application mechanism;
FIG. 6 is a right-side view of a third robot;
FIG. 7 is a flowchart showing an example of a flow of a substrate transfer method;
FIG. 8 is a schematic diagram illustrating the state of a mount frame in each step of the substrate transfer method;
FIG. 9 is a schematic diagram of a portion of the substrate transfer apparatus operating in a first step of the substrate transfer method;
FIG. 10 is a schematic diagram of a portion of the substrate transfer apparatus operating in a second step of the substrate transfer method;
FIG. 11 is a schematic diagram of a portion of the substrate transfer apparatus operating in a third step of the substrate transfer method;
FIG. 12 is a schematic diagram of a portion of the substrate transfer apparatus operating in a fourth step of the substrate transfer method;
FIG. 13 is a schematic diagram of a portion of the substrate transfer apparatus operating in a fifth step of the substrate transfer method;
FIG. 14 is a schematic diagram of a portion of the substrate transfer apparatus operating in a sixth step of the substrate transfer method;
FIG. 15 is a schematic diagram of a portion of the substrate transfer apparatus operating in an eighth step of the substrate transfer method;
FIG. 16 illustrates movement of a tape removal mechanism in the eighth step;
FIG. 17 illustrates movement of the tape removal mechanism in the eighth step;
FIG. 18 illustrates movement of the tape removal mechanism in the eighth step;
FIG. 19 illustrates a configuration example of a mounter device; and
FIG. 20 illustrates another configuration example of the mounter device.

### DESCRIPTION OF EMBODIMENTS

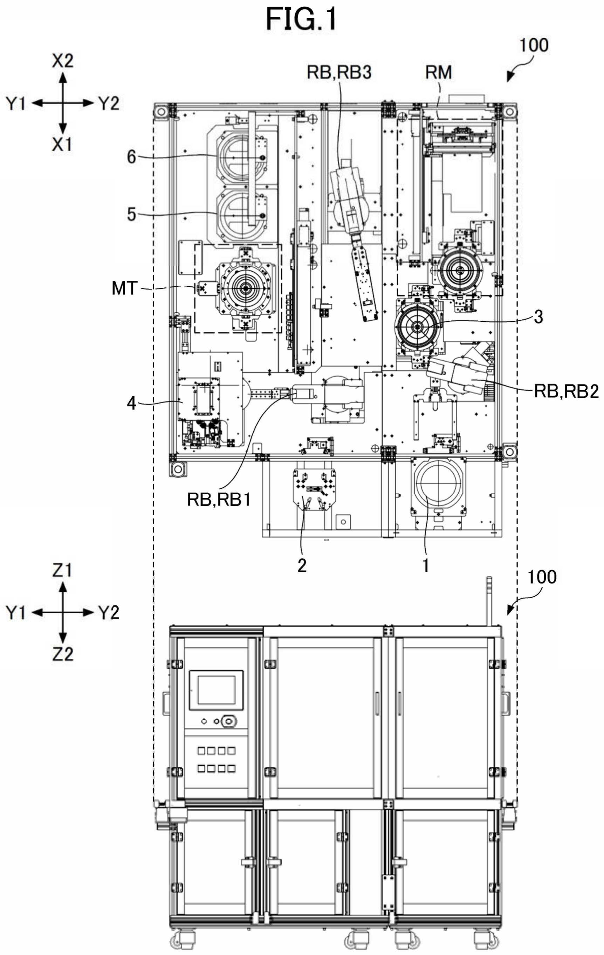

Hereinafter, a substrate transfer apparatus 100 according to an embodiment of the present invention will be described with reference to the drawings. FIG. 1 is a diagram illustrating a configuration example of the substrate transfer apparatus 100. Specifically, the upper diagram of FIG. 1 is a top view (plan view) of the substrate transfer apparatus 100, and the lower diagram of FIG. 1 is a front view of the substrate transfer apparatus 100.

In FIG. 1, X1 represents one direction of the X axis constituting the three-dimensional rectangular coordinate system, and X2 represents the other direction of the X axis. Y1 represents one direction of the Y axis constituting the three-dimensional rectangular coordinate system, and Y2 represents the other direction of the Y axis. Similarly, Z1 represents one direction of the Z axis constituting the three-dimensional orthogonal coordinate system, and Z2 represents the other direction of the Z axis. In FIG. 1, the X1 side of the substrate transfer apparatus 100 corresponds to the front side of the substrate transfer apparatus 100, and the X2 side of the substrate transfer apparatus 100 corresponds to the rear side (back side) of the substrate transfer apparatus 100. The Y1 side of the substrate transfer apparatus 100 corresponds to the left side of the substrate transfer apparatus 100, and the Y2 side of the substrate transfer apparatus 100 corresponds to the right side of the substrate transfer apparatus 100. The Z1 side of the substrate transfer apparatus 100 corresponds to the upper side of the substrate transfer apparatus 100, and the Z2 side of the substrate transfer apparatus 100 corresponds to the lower side of the substrate transfer apparatus 100. The same applies to the other members in the other figures. In the upper diagram of FIG. 1, for clarity, a ceiling panel covering the upper surface of the substrate transfer apparatus 100 is omitted.

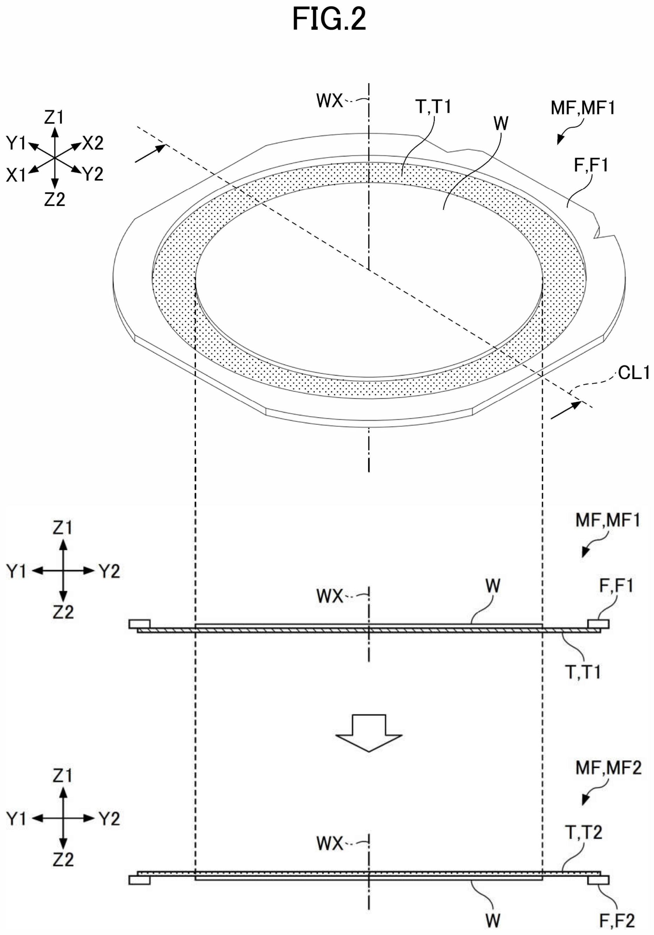

The substrate transfer apparatus 100 is configured to transfer a substrate from one mount frame MF to another mount frame MF. The mount frame MF is a substrate-including member used when a substrate such as a semiconductor wafer is handled in various devices. Specifically, as illustrated in FIG. 2, the mount frame MF includes a ring frame F, an adhesive tape T, and a wafer W, which is a semiconductor wafer. FIG. 2 illustrates an example of a configuration of the mount frame MF. The wafer W is a disk-shaped semiconductor wafer having a central axis WX, and is attached to a central portion of an adhesive tape T applied to one surface of the ring frame F, and is supported by the adhesive tape T inside the ring frame F.

The mount frame MF handled by the substrate transfer apparatus 100 includes a first mount frame MF1 and a second mount frame MF2. Specifically, the substrate transfer apparatus 100 is configured to transfer the wafer W from the first mount frame MF1 to the second mount frame MF2. For this reason, the wafer W in the second mount frame MF2 is the wafer W in the first mount frame MF1. In other words, the first mount frame MF1 is an input (material) to the substrate transfer apparatus 100, and the second mount frame MF2 is an output (product) from the substrate transfer apparatus 100.

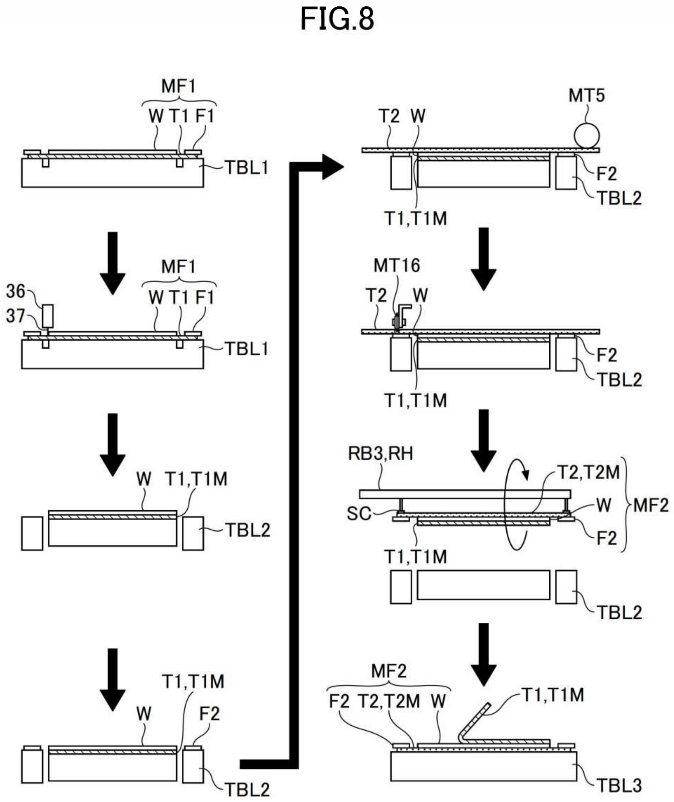

The upper diagram of FIG. 2 is a perspective view of the first mount frame MF1. In the upper diagram of FIG. 2, for clarity, the adhesive tape T (first adhesive tape T1) is depicted with a coarse dot pattern. The middle diagram of FIG. 2 is a cross-sectional view of the first mount frame MF1. Specifically, the middle diagram of FIG. 2 illustrates cross sections of the ring frame F (first ring frame F1), the adhesive tape T (first adhesive tape T1), and the wafer W when a virtual plane perpendicular to the XY plane including the cut line CL1 in the upper diagram of FIG. 2 is viewed from the X1 side. The lower diagram of FIG. 2 is a cross-sectional view of the second mount frame MF2 and corresponds to the middle diagram of FIG. 2. In the middle and lower diagrams of FIG. 2, for clarity, the cross sections of the wafer W and the ring frame F (first ring frame F1 and second ring frame F2) are depicted without pattern or shading (rendered as plain white areas). In the middle diagram of FIG. 2, for clarity, the cross section of the first adhesive tape T1 is depicted in a hatched pattern, and in the lower view of FIG. 2, the cross section of the adhesive tape T (second adhesive tape T2) is depicted in a dot pattern. The same is true when the side surfaces of the wafer W, the first adhesive tape T1, the second adhesive tape T2, and the ring frame F are depicted. In other words, in FIGS. 8, 10 through 14, 16, and 17, the side surfaces of the wafer W, the side surfaces of the first adhesive tape T1, the side surfaces of the second adhesive tape T2, and the side surfaces of the ring frame F are respectively depicted without pattern or shading (rendered as plain white areas), with a hatched pattern, with a dot pattern, and without pattern or shading (rendered as plain white areas).

Specifically, as illustrated in the upper and middle diagrams of FIG. 2, the first mount frame MF1 includes a first ring frame F1, a first adhesive tape T1, and a wafer **W.** In the first mount frame MF1, the wafer W is adhered to the first adhesive tape T1 applied to the lower surface of the first ring frame F1, and is thereby supported by the first adhesive tape T1 inside the first ring frame F1. The second mount frame MF2 includes a second ring frame F2, a second adhesive tape T2, and a wafer W, as illustrated in the lower diagram of FIG. 2. In the second mount frame MF2, the wafer W is adhered to the second adhesive tape T2 applied to the upper surface of the second ring frame F2, and is thereby supported by the second adhesive tape T2 inside the second ring frame F2. In the illustrated example, the first adhesive tape T1 is applied to the main surface of the wafer W, and the second adhesive tape T2 is applied to the back surface of the wafer W. The main surface of the wafer W is a surface on which a circuit pattern or the like is formed, and is also referred to as a "holding surface" as a surface for holding a circuit pattern or the like, and the back surface of the wafer W is a surface on the opposite side of the main surface, and is also referred to as a "non-holding surface".

In the illustrated example, the first adhesive tape T1 and the second adhesive tape T2 are different adhesive tapes, and the first ring frame F1 and the second ring frame F2 are different ring frames. However, the second ring frame F2 may be the first ring frame F1. In other words, the first ring frame F1 may be separated from the first adhesive tape T1 for reuse, and applied to the second adhesive tape T2.

In the illustrated example, the first adhesive tape T1 and the second adhesive tape T2 are formed from PET (polyethylene terephthalate) as a main material in order to provide rigidity to the wafer W; however, they may be formed from known materials other than PET. The first ring frame F1 and the second ring frame F2 are formed from stainless steel in the present embodiment; however, they may be formed of other metals or of materials other than metals, such as synthetic resin.

Referring back to FIG. 1, the substrate transfer apparatus 100 includes a first loader 1, a second loader 2, a wafer separation mechanism 3, an ultraviolet irradiation mechanism 4, a ring frame collector 5, a ring frame supplier 6, robots RB, a tape application mechanism MT, and a tape removal mechanism RM, as illustrated in the upper diagram in FIG. 1.

The first loader 1 is a device for loading the mount frame MF into the substrate transfer apparatus 100. The second loader 2 is a device for loading the wafer W (single unit) into the substrate transfer apparatus 100. In other words, the second loader 2 is configured in such a manner that the wafer W not supported by the adhesive tape T applied to a ring frame can be loaded into the substrate transfer apparatus 100. The inclusion of the second loader 2 in the substrate transfer apparatus 100 enables manufacturing the first mount frame MF1. One of the first loader 1 or the second loader 2 may be omitted.

The wafer separation mechanism 3 is configured to separate the mount frame MF into the wafer W and the ring frame F.

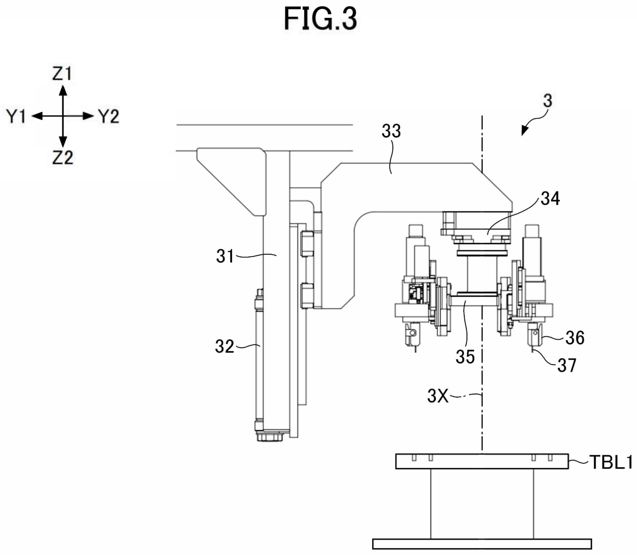

The wafer separation mechanism 3 will now be described in detail with reference to FIG. 3. FIG. 3 is a front view of the wafer separation mechanism 3. In the illustrated example, the wafer separation mechanism 3 includes a first table TBL1, a frame 31, a cutter elevation driver 32, an elevating frame 33, a cutter rotation driver 34, a rotary frame part 35, a cutter assembly 36, and a cutter blade 37. The cutter elevation driver 32 is configured to elevate and lower the elevating frame 33 with respect to the frame 31. The cutter rotation driver 34 is configured to rotate the rotary frame part 35 around a rotation axis 3X. The cutter assembly 36 is connected to the rotary frame part 35 so as to rotate together with the rotary frame part 35 around the rotation axis 3X, and is configured to have an elevating function for elevating and lowering the cutter blade 37 with respect to the rotary frame part 35. In the illustrated example, the wafer separation mechanism 3 is provided with two cutter assemblies 36 so as to be able to work on two different sizes of wafers W, but it may be configured to provide only one cutter assembly 36, or it may be configured to provide three or more cutter assemblies 36. By providing a plurality of cutter assemblies 36, the wafer separation mechanism 3 is able to work on a plurality of different sizes of wafers W.

The cutter assembly 36 may also have a function of sensing the cutter blade 37 being in contact with an object other than the adhesive tape T, such as the wafer W or foreign matter. This function can prevent damage to the wafer W and the cutter blade 37.

The cutter assembly 36 may also be provided with a heater for heating the cutter blade 37. Heating the cutter blade 37 makes it easier to cut the adhesive tape T, which can be expected to extend the lifespan of the cutter blade 37.

The ultraviolet irradiation mechanism 4 is configured to make the adhesive tape T easily removable from the substrate. In the illustrated example, the ultraviolet irradiation mechanism 4 irradiates the adhesive tape T applied to the wafer W with ultraviolet rays to harden the adhesive tape T so that the adhesive tape T can be easily peeled from the substrate. Specifically, the ultraviolet irradiation mechanism 4 irradiates the first adhesive tape T1 applied to the main surface of the wafer W with ultraviolet rays to harden the first adhesive tape T1 so that the first adhesive tape T1 can be easily peeled from the wafer W. The ultraviolet irradiation mechanism 4 may include an alignment mechanism for positioning the wafer W when the wafer W is irradiated with ultraviolet rays.

The ring frame collector 5 is configured to collect the ring frame F separated from the mount frame MF. In the illustrated example, the ring frame collector 5 is configured to collect the ring frames F separated from the mount frame MF by the wafer separation mechanism 3. Specifically, the ring frame collector 5 collects the first ring frames F1 constituting the first mount frame MF1 from the wafer separation mechanism 3 (first table TBL1) and piles them up at the central portion of the ring frame collector 5. The first ring frames F1 piled up by the ring frame collector 5 are typically carried out of the substrate transfer apparatus 100 by hand when the number of the first ring frames F1 reaches a certain number.

The ring frame supplier 6 is configured to supply the ring frames F one by one. In the illustrated example, the ring frame supplier 6 is configured to supply another ring frame F (second ring frame F2) in place of the ring frame F (first ring frame F1) separated from the mount frame MF by the wafer separation mechanism 3. Specifically, the ring frame supplier 6 is configured to supply the second ring frames F2 piled up in the central portion of the ring frame supplier 6 one by one to the tape application mechanism MT (second table TBL2). The second ring frames F2 stacked in the central portion of the ring frame supplier 6 are typically replenished manually.

The tape application mechanism MT is configured to apply the adhesive tape T to the wafer W and the ring frame F. The tape application mechanism MT is configured to cut the adhesive tape T applied to the wafer W and the ring frame F, along the ring frame F.

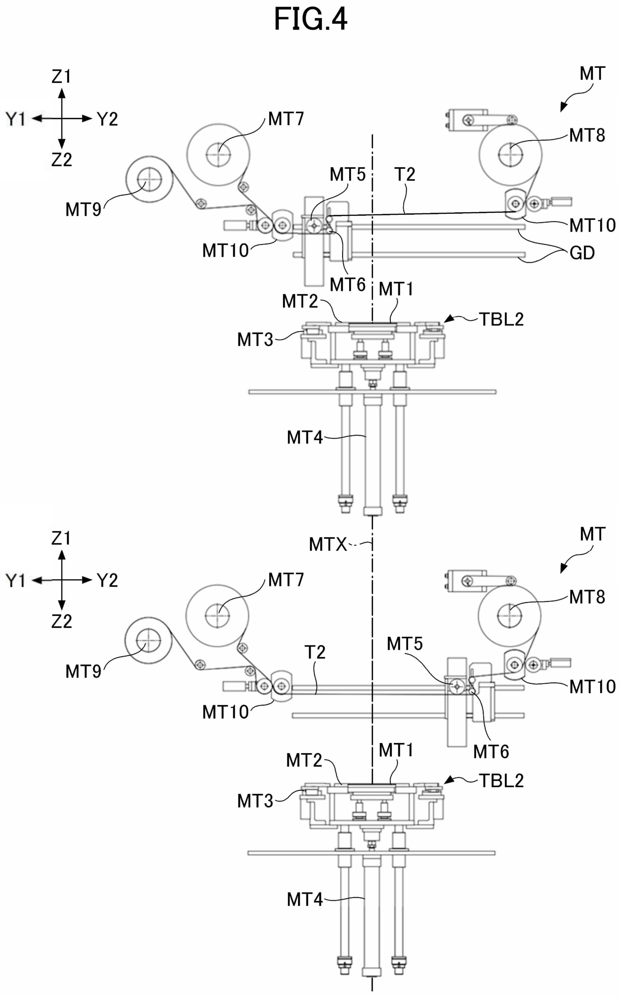

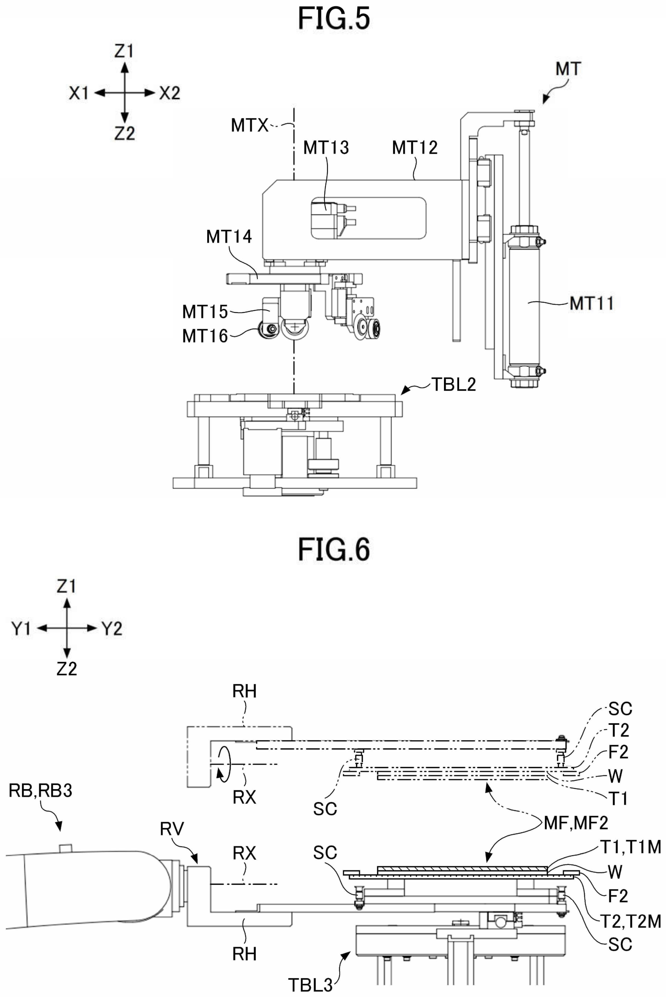

The tape application mechanism MT will now be described in detail with reference to FIGS. 4 and 5. FIG. 4 is a front view of a portion of the tape application mechanism MT, and FIG. 5 is a right-side view of another portion of the tape application mechanism MT. Specifically, the upper diagram of FIG. 4 illustrates a state in which the application roller MT5 and the peeling roller MT6 are positioned at the left end, and the lower diagram of FIG. 4 illustrates a state in which the application roller MT5 and the peeling roller MT6 are positioned at the right end. For the sake of clarity, FIG. 4 does not illustrate a second mechanism illustrated in FIG. 5 (cutter elevation driver MT11, elevating frame MT12, cutter rotation driver MT13, rotary frame part MT14, and cutter assembly MT15) above the second table TBL2, and FIG. 5 does not illustrate, on the other hand, a first mechanism illustrated in FIG. 4 (application roller MT5, peeling roller MT6, tape supply roller MT7, tape collection roller MT8, protective tape collection roller MT9, and tape holder MT10) above the second table TBL2. In the reality, however, the second mechanism is arranged slightly higher than the first mechanism so as to partially overlap with the first mechanism.

In the illustrated example, the tape application mechanism MT includes a wafer holder MT1, a ring frame holder MT2, a positioning unit MT3, an elevation driver MT4, an application roller MT5, a peeling roller MT6, a tape supply roller MT7, a tape collection roller MT8, a protective tape collection roller MT9, a tape holder MT10, a cutter elevation driver MT11, an elevating frame MT12, a cutter rotation driver MT13, a rotary frame part MT14, and a cutter assembly MT15.

The wafer holder MT1, the ring frame holder MT2, the positioning unit MT3, and the elevation driver MT4 constitute the second table TBL2. The application roller MT5, the peeling roller MT6, the tape supply roller MT7, the tape collection roller MT8, the protective tape collection roller MT9, and the tape holder MT10 constitute the first mechanism. The cutter elevation driver MT11, the elevating frame MT12, the cutter rotation driver MT13, the rotary frame part MT14, and the cutter assembly MT15 constitute the second mechanism. The first mechanism is configured to apply the second adhesive tape T2 to the wafer W and the second ring frame F2 and remove the excess portion of the second adhesive tape T2. The second mechanism is configured to apply the second adhesive tape T2 to the wafer W and cut and separate the second ring frame F2 into a circular portion and an excess portion.

The height of the wafer holder MT1 and the height of the ring frame holder MT2 can be separately adjusted by numerical control. With this configuration, the tape application mechanism MT can handle a case where the wafer W and the second ring frame F2 have different thicknesses, and can work with a plurality of types of wafers W having different thicknesses.

As illustrated in FIG. 5, the cutter elevation driver MT11 is configured to elevate and lower the elevating frame MT12. The cutter rotation driver MT13 is configured to rotate the rotary frame part MT14 around a rotation axis MTX. The cutter assembly MT15 is connected to the rotary frame part MT14 so as to rotate together with the rotary frame part MT14 around the rotation axis MTX, and is configured to have an elevating function for elevating and lowering a cutter blade MT16 with respect to the rotary frame part MT14. In the illustrated example, the tape application mechanism MT is provided with two cutter assemblies MT15 so as to be able to work on two different sizes of wafers W, but it may be configured to provide only one cutter assembly MT15, or it may be configured to provide three or more cutter assemblies MT15. Providing a plurality of cutter assemblies MT15 enables the tape application mechanism MT to work on a plurality of different sizes of wafers W.

The robot RB is an example of a transfer apparatus for transferring an article from one position to another position in the substrate transfer apparatus 100. The article is, for example, the wafer W, the mount frame MF, or the ring frame F. In the illustrated example, the robot RB is a multi-axis transfer robot, and includes a first robot RB1, a second robot RB2, and a third robot RB3, as illustrated in FIG. 1. The first robot RB1 is configured to transfer articles between the second loader 2, the wafer separation mechanism 3, the ultraviolet irradiation mechanism 4, and the tape application mechanism MT. The second robot RB2 is configured to transfer articles between the first loader 1, the wafer separation mechanism 3, and the tape removal mechanism RM. The third robot RB3 is configured to transfer articles between the wafer separation mechanism 3, the ring frame collector 5, the ring frame supplier 6, the tape application mechanism MT, and the tape removal mechanism RM.

A reversal mechanism RV of the robot RB will now be described with reference to FIG. 6. FIG. 6 is a right-side view of the third robot RB3. Specifically, the upper diagram of FIG. 6 (depicted with a two-dot chain line) is a right-side view of the third robot RB3 before vertical reversal, and the lower diagram of FIG. 6 (depicted with a solid line) is a right-side view of the third robot RB3 after vertical reversal. More specifically, the upper diagram of FIG. 6 illustrates the second mount frame MF2 in which the first adhesive tape T1 is held on the lower side of the wafer W by an adsorption pad SC of a robot hand RH attached to the distal end of the third robot RB3. The lower diagram of FIG. 6 illustrates the second mount frame MF2 released from the adsorption pad SC of the robot hand RH and placed on the third table TBL3 which is a part of the tape removal mechanism RM with the first adhesive tape T1 positioned on the upper side of the wafer W.

In the illustrated example, the reversal mechanism RV of the third robot RB3 is configured to rotate the robot hand RH around the rotation axis RX. The robot hand RH may be configured to be replaceable according to a purpose of use. The first robot RB1 and the second robot RB2 may be provided with a reversal mechanism similar to that of the third robot RB3. The robot hand RH of the third robot RB3 is provided with an adsorption pad SC for adsorbing the ring frame F, whereas the robot hand RH of the first robot RB1 may be provided with an adsorption pad for adsorbing the wafer W. The adsorption pad for adsorbing the wafer W may be a known adsorption mechanism, such as a vacuum chuck described in U.S. Pat. No. 8,858,756.

By using the robot RB, the substrate transfer apparatus 100 can realize complicated transfer (transfer including reversal) of an article from one position to another position in the forward direction compared to the case of using a conveyor or a transformer. The substrate transfer apparatus 100 can realize a transfer of an article from another position to one position in the reverse direction. However, the substrate transfer apparatus 100 may be configured to use a conveyor or a transfer system.

The tape removal mechanism RM is configured to peel the adhesive tape T applied to the substrate. In the illustrated example, the tape removal mechanism RM is configured to peel the first adhesive tape T1 applied to the main surface of the wafer W using a peeling tape.

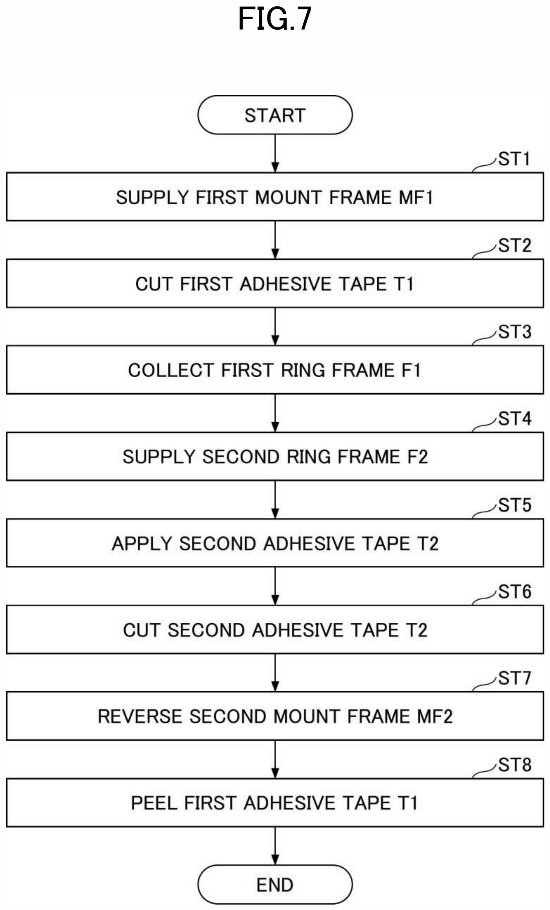

Hereinafter, a method in which the substrate transfer apparatus 100 transfers the wafer W from the first mount frame MF1 to the second mount frame MF2 (hereinafter referred to as the "substrate transfer method") will be described with reference to FIGS. 7 and 8. FIG. 7 is a flowchart illustrating an example of the flow of the substrate transfer method. FIG. 8 is a schematic diagram illustrating the state of the mount frame MF in each step of the substrate transfer method.

First, the substrate transfer apparatus 100 supplies (prepares) the first mount frame MF1 (first step ST1). The uppermost diagram on the left side of FIG. 8 illustrates the state of the first mount frame MF1 placed on the first table TBL1 of the wafer separation mechanism 3 in the first step ST1.

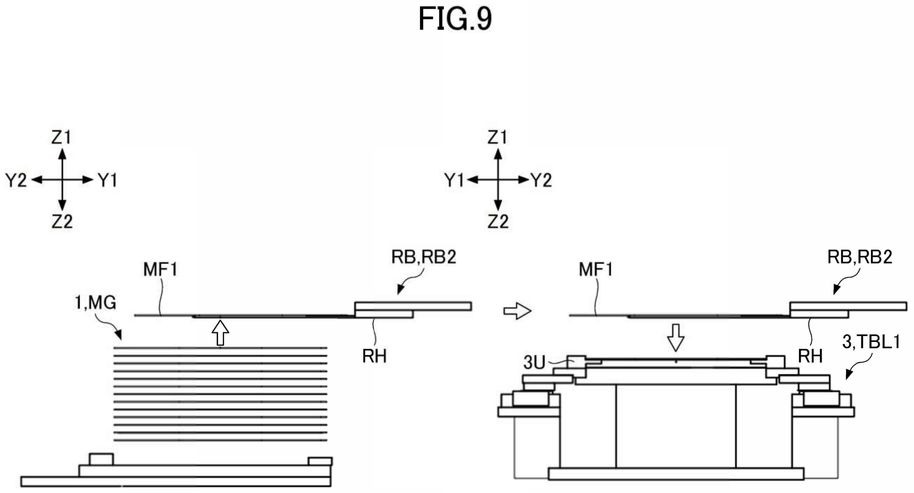

The movement of the substrate transfer apparatus 100 in the first step ST1 will now be described in detail with reference to FIG. 9. FIG. 9 is a schematic view of a part of the substrate transfer apparatus 100 operating in the first step ST1. Specifically, the left diagram of FIG. 9 is a front view of the first loader 1 on which a magazine MG is set, and the right diagram of FIG. 9 is a front view of the first table TBL1 on which the first mount frame MF1 unloaded from the magazine MG is placed. The magazine MG is a container for storing a plurality of first mount frames MF1 in a stacked state. The first mount frames MF1 are stored in the magazine MG, with the first adhesive tape T1 positioned below the wafer W as illustrated in the middle diagram of FIG. 2. In FIG. 9, for clarity, the first mount frames MF1 are illustrated in a simplified manner.

In the first step ST1, as illustrated in the left diagram of FIG. 9, the second robot RB2 inserts the robot hand RH between the first mount frame MF1 located at the top of the plurality of first mount frames MF1 stored in the magazine MG and the first mount frame MF1 located at the second top. Then, the second robot RB2 elevates the robot hand RH to unload one of the first mount frames MF1 from the magazine MG. Then, as illustrated in the right diagram of FIG. 9, the second robot RB2 moves the unloaded first mount frame MF1 onto the first table TBL1 of the wafer separation mechanism 3. Thereafter, the wafer separation mechanism 3 elevates a positioning unit 3U of the first table TBL1 to receive the first mount frame MF1. The positioning unit 3U typically has four supporting portions capable of supporting the outer periphery of the first mount frame MF1, and each supporting portion is configured to move in the radial direction of the first mount frame MF1. After receiving the first mount frame MF1, the positioning unit 3U descends while positioning the first mount frame MF1 with respect to the first table TBL1, and brings the first mount frame MF1 into contact with the supporting surface of the first table TBL1. The first table TBL1 holds the first mount frame MF1 by adsorbing the first mount frame MF1 with an adsorption pad (not illustrated).

Next, the substrate transfer apparatus 100 cuts the first adhesive tape T1 (second step ST2). The second diagram from the top on the left side of FIG. 8 illustrates a state of the first mount frame MF1 in which the first adhesive tape T1 is cut by the cutter blade 37 of the wafer separation mechanism 3 in the second step ST2.

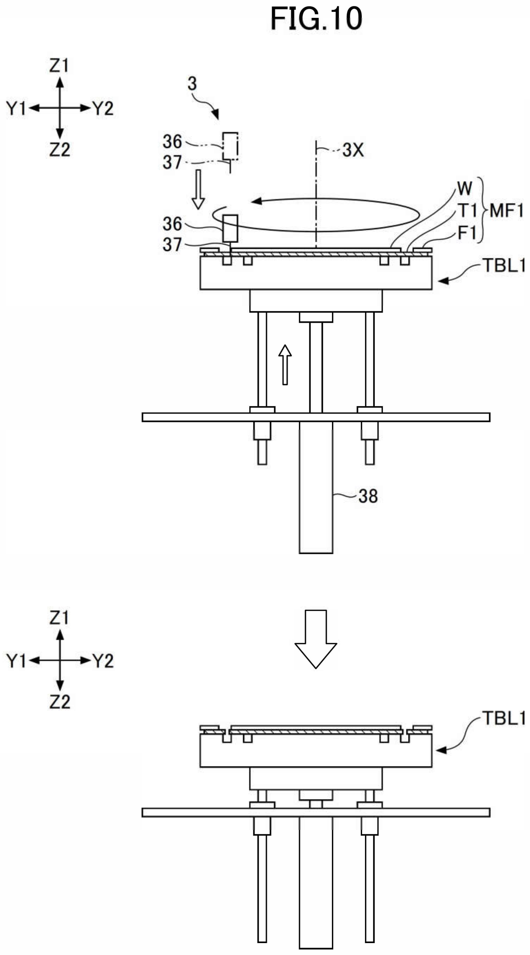

The movement of the substrate transfer apparatus 100 in the second step ST2 will now be described in detail with reference to FIG. 10. FIG. 10 is a schematic view of a part of the substrate transfer apparatus 100 operating in the second step ST2. Specifically, the upper diagram of FIG. 10 is a front view of a part of the wafer separation mechanism 3 when the cutting of the first adhesive tape T1 starts, and the lower diagram of FIG. 10 is a front view of a part of the wafer separation mechanism 3 after the first adhesive tape T1 is cut.

In the second step ST2, the wafer separation mechanism 3 is configured to separate the first mount frame MF1 transferred to the first table TBL1 into the wafer W and the first ring frame F1. After the first mount frame MF1 is placed on the first table TBL1, the wafer separation mechanism 3, as illustrated in the upper diagram of FIG. 10, elevates the first table TBL1 by an elevation driver 38 and lowers the cutter blade 37 by the cutter elevation driver 32 (see FIG. 3) and the cutter assembly 36 to bring the cutter blade 37 into contact with the first adhesive tape T1. In the illustrated example, in order to suppress or prevent damage to the wafer W, the wafer separation mechanism 3 brings the cutter blade 37 into contact with the first adhesive tape T1 at a position, in the radial direction of the wafer W, separated from the outer edge of the wafer W by a distance larger than the thickness of the wafer W.

Thereafter, the wafer separation mechanism 3 rotates the rotary frame part 35 (see FIG. 3) around the rotation axis 3X by the cutter rotation driver 34 (see FIG. 3) to cut the first adhesive tape T1 so that a circular cut line is formed. After the first adhesive tape T1 is cut, the wafer separation mechanism 3 lowers the first table TBL1 by the elevation driver 38. FIG. 10 illustrates a state of the first table TBL1 after the first table TBL1 is lowered.

Next, the substrate transfer apparatus 100 collects the first ring frame F1 (third step ST3). The third diagram from the top on the left side of FIG. 8 illustrates the state of the wafer W and the first adhesive tape T1 after the first ring frame F1 is collected in the third step ST3.

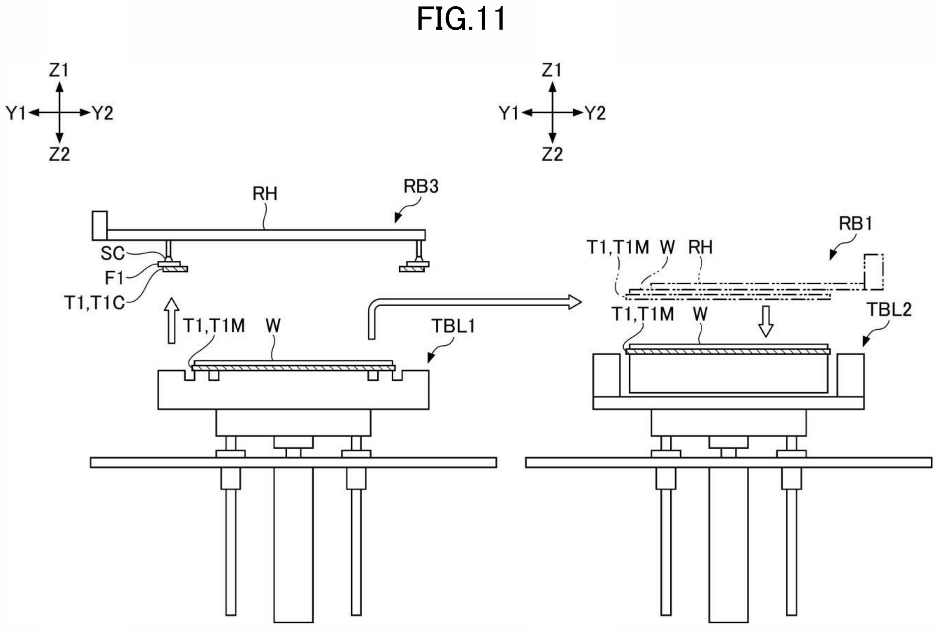

The movement of the substrate transfer apparatus 100 in the third step ST3 will now be described in detail with reference to FIG. 11. FIG. 11 is a schematic view of a part of the substrate transfer apparatus 100 operating in the third step ST3. Specifically, the left diagram of FIG. 11 is a front view of a part of the third robot RB3 for transferring the first ring frame F1 to the ring frame collector 5, and the right diagram of FIG. 11 is a front view of a part of the first robot RB1 for transferring the wafer W to the second table TBL2 of the tape application mechanism MT.

In the third step ST3, the third robot RB3 adsorbs the first ring frame F1 by the adsorption pad SC of the robot hand RH attached to the distal end of the third robot RB3 and lifts the first ring frame F1 by elevating the robot hand RH. Then, the third robot RB3 transfers the adsorbed first ring frame F1 to the ring frame collector 5. An annular outer surplus portion T1C, which is a part of the first adhesive tape T1, is applied to the first ring frame F1. The outer surplus portion T1C is a portion of the first adhesive tape T1 cut by the cutter blade 37 of the wafer separation mechanism 3 and collected (discarded) at the stage of the third step ST3 and has, at this stage, a shape surrounding an inner circular portion T1M, which is a remaining portion not collected (not discarded).

Thereafter, the first robot RB1 adsorbs the wafer W, which is still placed on the first table TBL1, by the adsorption mechanism of the robot hand RH attached to the distal end of the first robot RB1, and lifts the wafer W by elevating the robot hand RH. The first robot RB1 transfers the adsorbed wafer W to the second table TBL2 of the tape application mechanism MT. The inner circular portion T1M, which is a part of the first adhesive tape T1, is applied to the wafer W.

A portion depicted by a two-dot chain line in the right diagram of FIG. 11 illustrates the state of the first robot RB1, the wafer W, and the first adhesive tape T1 (inner circular portion T1M) before the wafer W is placed on the second table TBL2.

Thereafter, the first robot RB1 can place the wafer W and the first adhesive tape T1 (inner circular portion T1M) held by the robot hand RH onto the second table TBL2 by lowering the robot hand RH. The second table TBL2 holds the wafer W and the first adhesive tape T1 (inner circular portion T1M) by adsorbing the inner circular portion T1M applied to the main surface of the wafer W by an adsorption pad (not illustrated).

Next, the substrate transfer apparatus 100 supplies (prepares) the second ring frame F2 (fourth step ST4). The lowermost diagram on the left side of FIG. 8 illustrates the state of the wafer W and the first adhesive tape T1 (inner circular portion T1M) after the second ring frame F2 is supplied in the fourth step ST4.

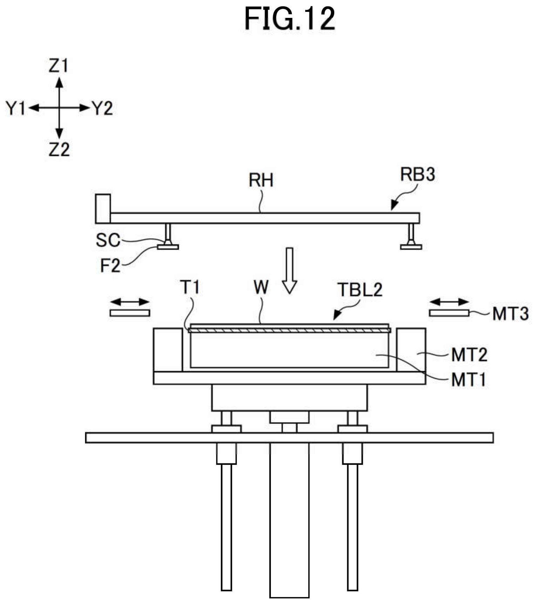

The movement of the substrate transfer apparatus 100 in the fourth step ST4 will now be described in detail with reference to FIG. 12. FIG. 12 is a schematic view of a part of the substrate transfer apparatus 100 operating in the fourth step ST4. Specifically, FIG. 12 is a front view of a part of the third robot RB3, which transfers the second ring frame F2 from the ring frame supplier 6 to the second table TBL2 of the tape application mechanism MT.

In the fourth step ST4, the third robot RB3 transfers the first ring frame F1 to the ring frame collector 5 by the robot hand RH, and then adsorbs the second ring frame F2 in the ring frame supplier 6 by the adsorption pad SC. Then, the third robot RB3 lifts the adsorbed second ring frame F2 and transfers it to the second table TBL2.

The second table TBL2 receives the second ring frame F2 by the positioning unit MT3. After receiving the second ring frame F2, the positioning unit MT3 brings the second ring frame F2 into contact with the support surface of the ring frame holder MT2 while positioning the second ring frame F2 with respect to the ring frame holder MT2 of the second table TBL2. The ring frame holder MT2 adsorbs the second ring frame F2 by an adsorption pad (not illustrated) and holds the second ring frame F2. The wafer W to which the inner circular portion T1M of the first adhesive tape T1 is applied is already placed on the wafer holder MT1 of the second table TBL2.

Next, the substrate transfer apparatus 100 cuts the second adhesive tape T2 (fifth step ST5). The uppermost diagram on the right side of FIG. 8 illustrates the state of the wafer W and the first adhesive tape T1 (inner circular portion T1M) after the second adhesive tape T2 is applied in the fifth step ST5.

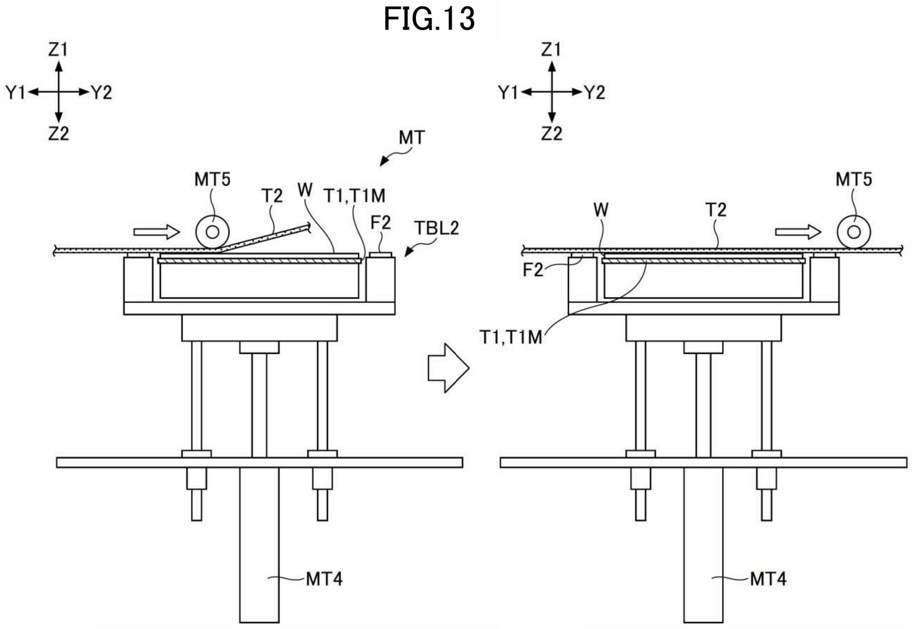

The movement of the substrate transfer apparatus 100 in the fifth step ST5 will now be described in detail with reference to FIG. 13. FIG. 13 is a schematic view of a part of the substrate transfer apparatus 100 operating in the fifth step ST5. Specifically, the left diagram of FIG. 13 is a front view of a part of the tape application mechanism MT when the application roller MT5 is applying the second adhesive tape T2 to the wafer W and the second ring frame F2. The right diagram of FIG. 13 is a front view of a part of the tape application mechanism MT after the second adhesive tape T2 is applied to the wafer W and the second ring frame F2 by the application roller MT5.

In the fifth step ST5, as illustrated in the upper diagram of FIG. 4, the second adhesive tape T2 stands by above the second table TBL2 in a state of being stretched in the Y-axis direction. The tape application mechanism MT elevates the second table TBL2 by the elevation driver MT4 so that the height of each of the upper surfaces of the second ring frame F2 and the wafer W substantially coincides with the height of the lower surface of the second adhesive tape T2.

Thereafter, as schematically illustrated in the left diagram of FIG. 13, the tape application mechanism MT moves the application roller MT5 in the Y2 direction along the guide GD (see the upper diagram of FIG. 4). The application roller MT5 moves in the Y2 direction while pressing the second adhesive tape T2 against the second ring frame F2 and the wafer W, respectively. The second adhesive tape T2 is thereby applied to the upper surface of each of the second ring frame F2 and the wafer W.

Next, the substrate transfer apparatus 100 cuts the second adhesive tape T2 (sixth step ST6). The second diagram from the top on the right side of FIG. 8 illustrates the state of the wafer W, the first adhesive tape T1 (inner circular portion T1M), and the second adhesive tape T2 when the cutter blade MT16 for cutting the second adhesive tape T2 is pressed against the second adhesive tape T2 in the sixth step ST6.

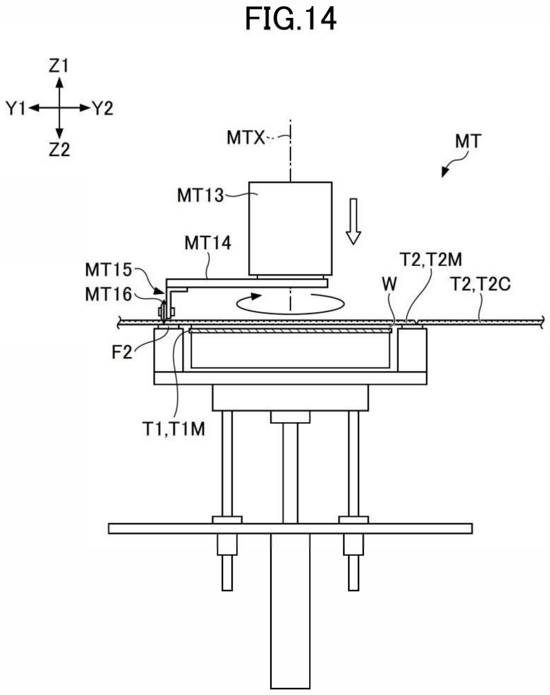

The movement of the substrate transfer apparatus 100 in the sixth step ST6 will now be described in detail with reference to FIG. 14. FIG. 14 is a schematic view of a part of the substrate transfer apparatus 100 operating in the sixth step ST6. Specifically, FIG. 14 is a front view of a part of the tape application mechanism MT when the cutter blade MT16 is cutting the second adhesive tape T2.

In the sixth step ST6, the tape application mechanism MT moves the application roller MT5 in the Y1 direction, then lowers the cutter blade MT16 by the cutter assembly MT15, pierces the cutting edge of the cutter blade MT16 to the second adhesive tape T2, and presses the cutting edge of the cutter blade MT16 against the second ring frame F2. Then, the tape application mechanism MT rotates the rotary frame part MT14 around the rotation axis MTX by 360 degrees by the cutter rotation driver MT13. Since the cutter assembly MT15 and the cutter blade MT16 are attached to the tip of the rotary frame part MT14, the tape application mechanism MT can cut the second adhesive tape T2 along the second ring frame F2 and separate the second adhesive tape T2 into the inner circular portion T2M and the outer surplus portion T2C.

The outer surplus portion T2C is a portion of the second adhesive tape T2 cut by the cutter blade MT16 and removed (discarded) at the stage of the sixth step ST6 and has, at this stage, a shape surrounding an inner circular portion T2M, which is a remaining portion not removed (not discarded).

After the second adhesive tape T2 is separated into the inner circular portion T2M and the outer surplus portion T2C, the tape application mechanism MT moves the removal roller MT6 in the Y1 direction along the guide GD and peels the outer surplus portion T2C by the removal roller MT6, as illustrated in FIG. 4. The peeled outer surplus portion T2C is wound and collected by the protective tape collection roller MT9.

Next, the substrate transfer apparatus 100 reverses the second mount frame MF2 (seventh step ST7). The third diagram from the top on the right side of FIG. 8 illustrates the state of the second mount frame MF2 lifted from the second table TBL2 by the third robot RB3 in the seventh step ST7. The second mount frame MF2 is composed of the wafer W, the second ring frame F2, and the second adhesive tape T2 (inner circular portion T2M), and at this stage, the first adhesive tape T1 (inner circular portion T1M) is attached to the main surface of the wafer W.

In the seventh step ST7, the third robot RB3 rotates the robot hand RH around the rotation axis RX by the reversal mechanism RV, reverses the second mount frame MF2 vertically so that the inner circular portion T1M of the first adhesive tape T1 faces upward, and then places the second mount frame MF2 on the third table TBL3 of the tape removal mechanism RM, as illustrated in the lower diagram of FIG. 6.

Next, the substrate transfer apparatus 100 removes the first adhesive tape T1 (eighth step ST8). The lowermost diagram on the right side of FIG. 8 illustrates the state of the second mount frame MF2 when the inner circular portion T1M of the first adhesive tape T1 is being peeled off in the eighth step ST8. The second mount frame MF2 after the inner circular portion T1M is peeled off in the lowermost diagram on the right side of FIG. 8 corresponds to a vertically inverted version of the second mount frame MF2 illustrated in the lower diagram of FIG. 2, which is an output (product) from the substrate transfer apparatus 100.

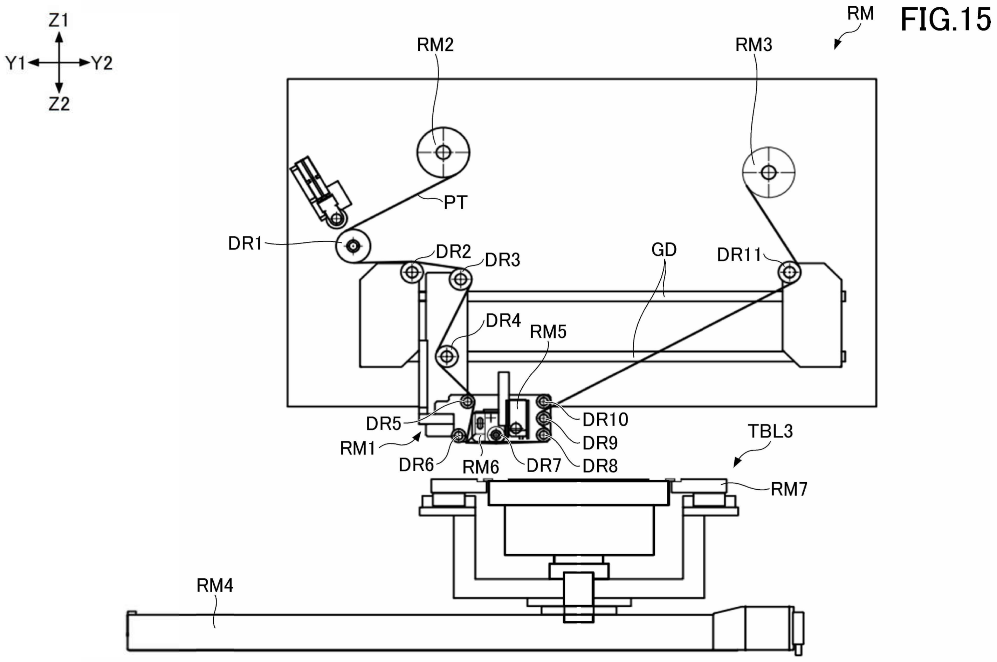

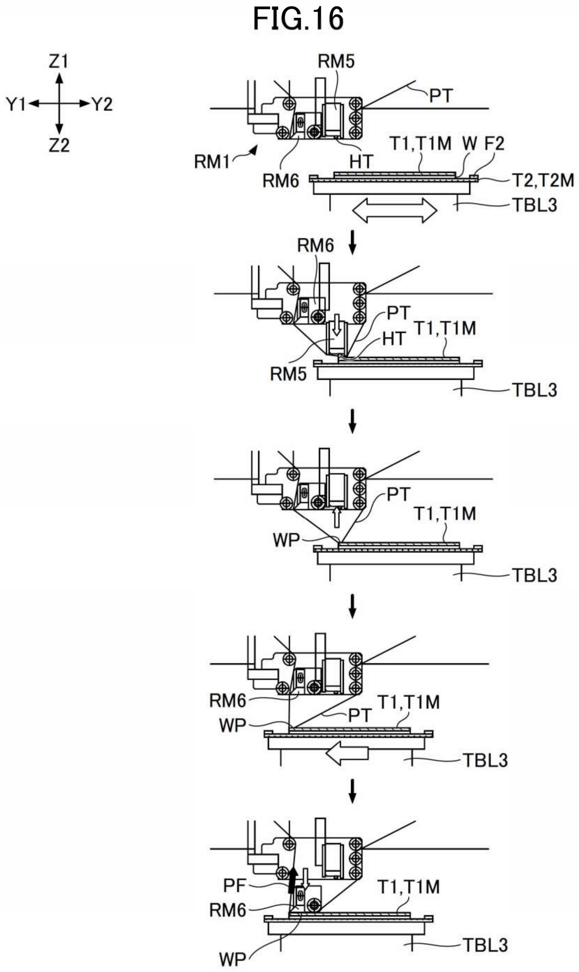

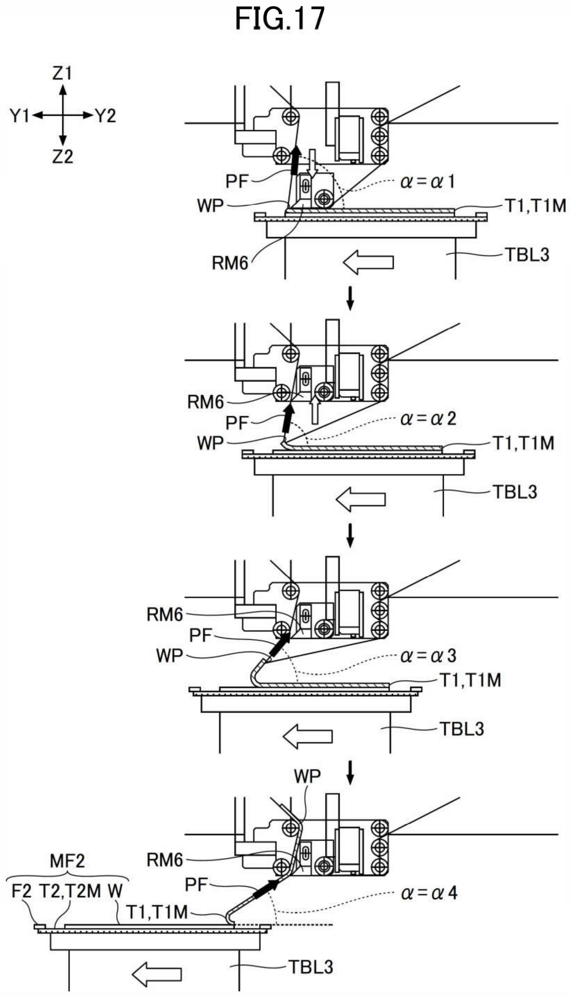

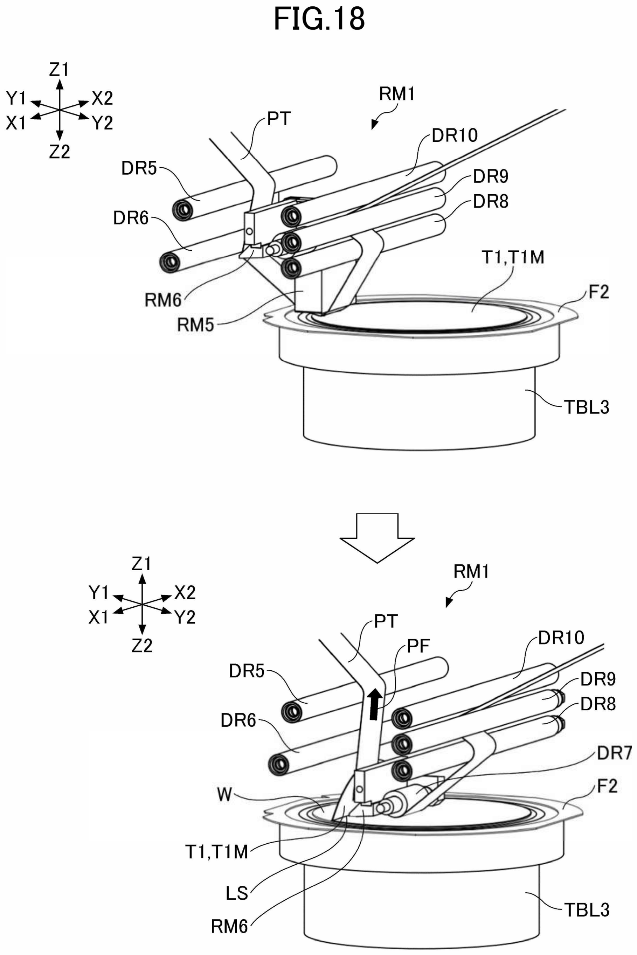

The movement of the substrate transfer apparatus 100 in the eighth step ST8 will now be described in detail with reference to FIGS. 15 through 18. FIG. 15 is a front view of the tape removal mechanism RM, and FIGS. 16 and 17 are front views of the removal head RM1, which is a part of the tape removal mechanism RM. Specifically, five diagrams in FIG. 16 are diagrams for explaining a series of movements of the removal head RM1 until the peeling of the first adhesive tape T1 starts, and the series of movements of the removal head RM1 proceeds from the uppermost diagram to the lowermost diagram. Four diagrams in FIG. 17 are diagrams for explaining a series of movements of the removal head RM1 after the peeling of the first adhesive tape T1 starts, and the series of movements of the removal head RM1 proceeds from the uppermost diagram to the lowermost diagram. FIG. 18 is a perspective view of the removal head RM1. Specifically, the upper diagram in FIG. 18 illustrates a state of the removal head RM1 before the peeling of the first adhesive tape T1 starts, and the lower diagram in FIG. 18 illustrates a state of the removal head RM1 during the peeling of the first adhesive tape T1.

The tape removal mechanism RM is configured to peel the first adhesive tape T1 applied to the main surface of the wafer W using a peeling tape PT. In the illustrated example, as illustrated in FIG. 15, the tape removal mechanism RM includes a third table TBL3, a removal head RM1, a peeling tape collection roller RM2, a peeling tape supply roller RM3, a slider RM4, a heat seal RM5, a removal wedge RM6, and a driven roller DR. The driven roller DR includes a first driven roller DR1 through an eleventh driven roller DR11. The third table TBL3 includes a positioning unit RM7.

In the eighth step ST8, the third table TBL3 positions the second mount frame MF2 with respect to the third table TBL3 by the positioning unit RM7, and holds the second mount frame MF2 by adsorbing the second mount frame MF2 by an adsorption pad (not illustrated). As illustrated in FIG. 16, the second mount frame MF2 is in a state where the inner circular portion T1M of the first adhesive tape T1 is applied to the main surface of the wafer W.

Then, as illustrated in the uppermost view of FIG. 16, the tape removal mechanism RM moves the third table TBL3 by using the slider RM4 in order to position the end of the wafer W (the inner circular portion T1M of the first adhesive tape T1) right under a heater HT of the heat seal RM5. At this time, the tape removal mechanism RM may move the removal head RM1 along the guide GD (see FIG. 15), or may move the removal head RM1 and the third table TBL3 simultaneously.

Then, as illustrated in the second diagram from the top of FIG. 16, the tape removal mechanism RM lowers the heat seal RM5, presses a portion of the peeling tape PT against the end of the inner circular portion T1M by the heater HT, and heats a portion of the peeling tape PT to be welded to the end of the inner circular portion T1M. The upper diagram of FIG. 18 illustrates the state of the removal head RM1 (heat seal RM5) at this time.

Then, as illustrated in the third diagram from the top of FIG. 16, the tape removal mechanism RM elevates the heat seal RM5. Even when the heat seal RM5 is elevated, since a welded portion WP of the peeling tape PT is welded to the end of the inner circular portion T1M, the welded portion WP is not elevated together with the heat seal RM5 at this stage.

Thereafter, as illustrated in the fourth diagram from the top in FIG. 16, the tape removal mechanism RM moves the third table TBL3 in the Y1 direction by using the slider RM4 to position the welded portion WP just under the tip of the removal wedge RM6, which is an example of the peeling member. At this time, the tape removal mechanism RM may move the removal head RM1 along the guide GD (see FIG. 15), or may move the removal head RM1 and the third table TBL3 simultaneously.

Thereafter, as illustrated in the lowermost diagram in FIG. 16, the tape removal mechanism RM lowers the removal wedge RM6 so that the welded portion WP is pressed by the tip of the removal wedge RM6.

Thereafter, as illustrated in the uppermost diagram in FIG. 17, the tape removal mechanism RM drives the peeling tape collection roller RM2 (see FIG. 15) and the peeling tape supply roller RM3 (see FIG. 15) to generate a peeling force PF. The tape removal mechanism RM moves the third table TBL3 in the Y1 direction using the slider RM4.

At this time, a peeling angle α, which is an angle of the line of action of the peeling force PF with respect to the upper surface (horizontal plane) of the wafer W, becomes the value α1, and the peeling of the first adhesive tape T1 (inner circular portion T1M) from the upper surface of the wafer W starts. The peeling angle α is an angle differing from a wedge angle, which is the angle of the tip of the removal wedge RM6, and is typically larger than the wedge angle. The lower diagram of FIG. 18 illustrates a state similar to that of the removal head RM1 (removal wedge RM6) at this time. In the strict sense, the lower diagram of FIG. 18 illustrates a state when the peeling of the first adhesive tape T1 (inner circular portion T1M) from the upper surface of the wafer W has progressed further.

As described above, the tape removal mechanism RM can pull the welded portion WP substantially directly upward with an appropriate peeling force PF while pressing the first adhesive tape T1 (inner circular portion T1M) with the removal wedge RM6. Therefore, the tape removal mechanism RM can start peeling the first adhesive tape T1 (inner circular portion T1M) from the upper surface of the wafer W without causing the wafer W to crack or the like.

Thereafter, the tape removal mechanism RM elevates the removal wedge RM6 as illustrated in the second diagram from the top of FIG. 17. As illustrated in the second, third, and fourth (lowermost) diagrams from the top of FIG. 17, the tape removal mechanism RM continues collecting the peeling tape PT and the first adhesive tape T1 (inner circular portion T1M) by the peeling tape collection roller RM2 (see FIG. 15) while moving the third table TBL3 in the Y1 direction so that the peeling angle α becomes a value α2, a value α3, and a value α4 that are smaller than the value α1 at the time when peeling starts. At this time, the tape removal mechanism RM may move the removal head RM1 along the guide GD (see FIG. 15), or may move the removal head RM1 and the third table TBL3 simultaneously.

In the illustrated example, the peeling angle α is controlled in such a manner that it becomes maximum at a value α1 at the time when peeling starts, becomes smaller in the order of a value α2 and a value α3, and becomes minimum at a value α4 at the time when peeling ends. In other words, the peeling angle α is controlled in such a manner that it becomes progressively smaller during the period between the time when peeling starts and the time when peeling ends. Alternatively, the peeling angle α may be controlled in such a manner that a value α3 is maintained after the peeling angle α becomes progressively smaller from a value α1 to the value α3. In other words, the peeling angle α may be controlled in such a manner that it becomes substantially constant in a partial period between the time when peeling starts and the time when peeling ends. Alternatively, the peeling angle α may be controlled in such a manner that it is increased in a partial period between the time when peeling starts and the time when peeling ends. For example, the tape removal mechanism RM may be controlled in such a manner that the peeling angle α is maintained or increased in a period in which the peeling width becomes larger, and the peeling angle α is decreased in a period in which the peeling width becomes smaller. The peeling width is the length of the portion of the actually peeled portion of the inner circular portion T1M in the X-axis direction, and it increases as the peeling line LS (see the lower diagram in FIG. 18) approaches the center of the circular wafer W, becomes maximum when the peeling line LS passes through the center of the circular wafer W, and decreases as the peeling line LS moves away from the center of the circular wafer W. The peeling line LS corresponds to a boundary line between a portion of the inner circular portion T1M that has already been peeled and a portion that has not yet been peeled.

By controlling the peeling angle α in the above-described manner, the tape removal mechanism RM can prevent the wafer W from being pulled in an undesired direction by an undesired force via the first adhesive tape T1 (inner circular portion T1M) by the peeling tape PT, so that damage due to cracking or the like of the wafer W can be suppressed.

In the above-described embodiment, the peeling tape PT is a thermally welded tape that is heated by the heat seal RM5 and welded to the first adhesive tape T1 (inner circular portion T1M), but it may be an adhesive tape that can be adhered to the first adhesive tape T1 (inner circular portion T1M). In this case, adhesion of the peeling tape PT to the first adhesive tape T1 (inner circular portion T1M) may be realized by pressing the seventh driven roller DR7 (see FIG. 15). The heat seal RM5 may be omitted.

The tape removal mechanism RM may be configured to control a peeling force by adjusting the driving force of the peeling tape collection roller RM2. For example, the tape removal mechanism RM may be configured to maintain the peeling force constant during peeling, or to cause the peeling force to differ between the time when peeling starts and the time when peeling ends. Specifically, the peeling force may be controlled so as to gradually decrease during the period between the time when peeling starts and the time when peeling ends.

In the above-described embodiment, the tape removal mechanism RM elevates the removal wedge RM6 after the peeling of the first adhesive tape T1 (inner circular portion T1M) from the wafer W starts. However, the tape removal mechanism RM may keep the removal wedge RM6 in contact with the upper surface of the first adhesive tape T1 (inner circular portion T1M) without elevating the removal wedge RM6. With this configuration, when the wafer W has already been diced, the removal wedge RM6 can bring an advantageous effect of preventing the diced chips or similar fragments from adhering to the first adhesive tape T1 to be peeled and from lifting off of the substrate (wafer W). In the illustrated example, the removal wedge RM6 is configured in such a manner that the width thereof in the X-axis direction is slightly larger than the width of the peeling tape PT, as illustrated in the lower diagram of FIG. 18, but may be configured in such a manner that the width thereof in the X-axis direction is larger than the width of the wafer W when the removal wedge RM6 has a function of preventing the diced chips or similar fragments from lifting off of the substrate.

As described above, the substrate transfer apparatus 100 according to the embodiment of the present disclosure is configured to transfer the substrate (wafer W) to which the first adhesive tape (first adhesive tape T1) is applied on the holding surface side to the second adhesive tape (second adhesive tape T2), as illustrated in FIG. 2. Specifically, the substrate transfer apparatus 100 includes the tape application mechanism MT for applying the second adhesive tape (second adhesive tape T2) to the ring frame F (second ring frame F2) and the non-holding surface side of the substrate (wafer W) as illustrated in FIG. 13, the tape cutter (cutter blade MT16) for cutting the second adhesive tape (second adhesive tape T2) along the outer shape of the ring frame F (second ring frame F2) as illustrated in FIG. 14, the reversal mechanism RV for reversing the substrate (wafer W) adhered and held in the ring frame F (second ring frame F2) through the second adhesive tape (second adhesive tape T2) as illustrated in FIG. 6, and the tape removal mechanism RM for peeling the first adhesive tape (first adhesive tape T1) from the substrate (wafer W) as illustrated in FIG. 15. As illustrated in FIG. 17, the tape removal mechanism RM is configured to change the peeling angle α during a period between the time when peeling starts and the time when peeling ends.

With this configuration, the substrate transfer apparatus 100 can bring an advantageous effect of suppressing damage to the substrate (wafer W) when peeling the adhesive tape T (first adhesive tape T1) from the substrate (wafer W).

The tape removal mechanism RM may be included in the mounter device MD. The mounter device MD is a device for applying the adhesive tape T to the ring frame F and the substrate (wafer W), or a device for separating the ring frame F adhered to the adhesive tape T from the substrate (wafer W), and may be, for example, a device for assembling the mount frame MF or a device for separating the mount frame MF. Specifically, the mounter device MD may be a normal mounter device NMD for manufacturing the mount frame MF by applying the adhesive tape T to the substrate (wafer W) and the ring frame F positioned on a table. Alternatively, the mounter device MD may be a reversal mounter device RMD for separating the mount frame MF placed on the table into the substrate (wafer W) and the ring frame F. The mounter device MD may have the tape removal mechanism RM for peeling the adhesive tape T applied to the substrate (wafer W). The tape removal mechanism RM may be configured to change the peeling angle α during the period between the time when peeling starts and the time when peeling ends.

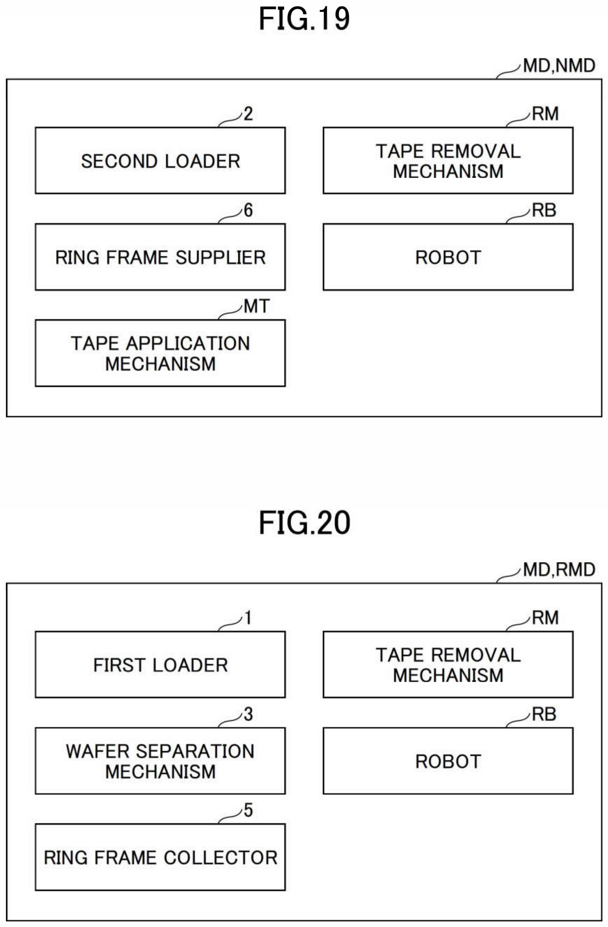

More specifically, the normal mounter device NMD, which is an example of the mounter device MD, may include the second loader 2, the ring frame supplier 6, the tape application mechanism MT, the robot RB, and the tape removal mechanism RM, as illustrated in FIG. 19. As illustrated in FIG. 20, the reversal mounter device RMD, which is another example of the mounter device MD, may include the first loader 1, the wafer separation mechanism 3, the ring frame collector 5, the robot RB, and the tape removal mechanism RM. The mounter device MD may be configured as a combination of the normal mounter device NMD and the reversal mounter device RMD.

With this configuration, the mounter device brings an advantageous effect of suppressing damage to the substrate (wafer W) when peeling the adhesive tape T from the substrate (wafer W).

As illustrated in FIG. 15, the tape removal mechanism RM may include a heating device (heat seal RM5) for heating the peeling tape PT in contact with the adhesive tape T (first adhesive tape T1), and a collection mechanism (peeling tape collection roller RM2) for collecting the peeling tape PT. In this case, as illustrated in FIG. 16, the peeling tape PT is heated by the heating device (heat seal RM5) and welded to the adhesive tape T (first adhesive tape T1), and the adhesive tape T (first adhesive tape T1) is pulled by the peeling tape PT collected by the collection mechanism (peeling tape collection roller RM2) and peeled from the substrate (wafer W) as illustrated in FIG. 17.

With this configuration, the tape removal mechanism RM can utilize a thermally welded tape as the peeling tape PT, and therefore brings an advantageous effect of increasing the bonding strength between the peeled adhesive tape T (first adhesive tape T1) and the peeling tape PT, as compared to the case where the adhesive tape is utilized as the peeling tape PT. As a result, the tape removal mechanism RM brings an advantageous effect of suppressing variations in peeling force, which is a force for peeling the adhesive tape T (first adhesive tape T1) from the substrate (wafer W), and further suppressing damage to the substrate (wafer W) when peeling the adhesive tape T (first adhesive tape T1) from the substrate (wafer W).

The tape removal mechanism RM may be configured as a separate tape removal device independent of the substrate transfer apparatus 100 or the mounter device. In this case, the tape removal device may be, for example, a device for peeling the adhesive tape T (second adhesive tape T2) applied to the substrate (wafer W), and may be configured to change the peeling angle α during the period between the time when peeling starts and the time when peeling ends.

With this configuration, the tape removal device brings an advantageous effect of suppressing damage to the substrate (wafer W) when peeling the adhesive tape T from the substrate (wafer W).

The substrate transfer apparatus 100 according to the embodiment of the present disclosure is configured to execute the substrate transfer method illustrated in FIGS. 7 and 8. The substrate transfer method is a method for transferring a substrate (wafer W) having a first adhesive tape (first adhesive tape T1) applied to the holding surface side to a second adhesive tape (second adhesive tape T2). Specifically, the substrate transfer method includes: a step (fifth step ST5) of applying a second adhesive tape (second adhesive tape T2) to a ring frame F (second ring frame F2) and the non-holding surface side of a substrate (wafer W); a step (sixth step ST6) of cutting the second adhesive tape (second adhesive tape T2) along the outer shape of the ring frame F (second ring frame F2); a step (seventh step ST7) of reversing the substrate (wafer W) adhered and held in the ring frame F (second ring frame F2) via the second adhesive tape (second adhesive tape T2); and a step (eighth step ST8) of peeling the first adhesive tape (inner circular portion T1M of the first adhesive tape T1) from the substrate (wafer W). In the tape peeling step (eighth step ST8), the first adhesive tape (inner circular portion T1M of the first adhesive tape T1) is peeled from the substrate (wafer W) in such a manner that the peeling angle α is caused to differ between the time when peeling starts and the time when peeling ends.

With this substrate transfer method, the substrate transfer apparatus 100 can suppress damage to the substrate (wafer W) when peeling the adhesive tape T (first adhesive tape T1) from the substrate (wafer W).

The substrate transfer apparatus 100, the mounter device, or the tape removal device may be configured to execute the tape removal method. The tape removal method is a method for peeling the adhesive tape T (inner circular portion T1M of the first adhesive tape T1) applied to the substrate (wafer W). Specifically, the tape removal method includes a step of applying the peeling tape PT to the adhesive tape T (inner circular portion T1M of the first adhesive tape T1) (see the second drawing from the top in FIG. 16), and a step of peeling the adhesive tape T (inner circular portion T1M of the first adhesive tape T1) to which the peeling tape PT is adhered from the substrate (wafer W) by collecting (winding) the peeling tape PT (see FIG. 17). In the tape peeling step, the adhesive tape T (inner circular portion T1M of the first adhesive tape T1) is peeled from the substrate (wafer W) in such a manner that the peeling angle α is caused to differ between the time when peeling starts (value α1) and the time when peeling ends (value α4).

With this tape removal method, the substrate transfer apparatus 100, the mounter device, or the tape removal device can bring an advantageous effect of suppressing damage to the substrate (wafer W) when peeling the adhesive tape T (first adhesive tape T1) from the substrate (wafer W).

In the applying step, as illustrated in the second drawing from the top of FIG. 16, the peeling tape PT may be heated and welded to the adhesive tape T (inner circular portion T1M of the first adhesive tape T1) while being pressed against the adhesive tape T (inner circular portion T1M of the first adhesive tape T1).

With this applying step, the substrate transfer apparatus 100, the mounter, or the tape removal device can utilize a thermally welded tape as the peeling tape PT, and brings an advantageous effect of increasing the bonding strength between the peeled adhesive tape T (first adhesive tape T1) and the peeling tape PT as compared to the case where the adhesive tape is utilized as the peeling tape PT. As a result, the tape removal mechanism RM brings an advantageous effect of suppressing variations in peeling force, which is a force for peeling the adhesive tape T (first adhesive tape T1) from the substrate (wafer W), and further suppressing damage to the substrate (wafer W) when peeling the adhesive tape T (first adhesive tape T1) from the substrate (wafer W).

Preferred embodiments of the present invention have been described in detail. However, the present invention is not limited to the above-described embodiments. Various modifications and substitutions may be applied to the above-described embodiments without departing from the scope of the present invention. Each of the features described with reference to the above-described embodiments may be suitably combined as long as there is no technical conflict.

This application claims priority from Japanese Patent Application No. 2023-064943, filed on April 12, 2023, the entire contents of which are hereby incorporated by reference.

### REFERENCE SIGNS LIST

- 1: First loader
- 2: Second loader
- 3: Wafer separation mechanism
- 3U: Positioning unit
- 3X: Rotation axis
- 4: Ultraviolet irradiation mechanism
- 5: Ring frame collector
- 6: Ring frame supplier
- 31: Frame
- 32: Cutter elevation driver
- 33: Elevating frame
- 34: Cutter rotation driver
- 35: Rotary frame part
- 36: Cutter assembly
- 37: Cutter blade
- 38: Elevation driver
- 100: Substrate transfer apparatus
- DR: Driven roller
- DR1: First driven roller
- DR2: Second driven roller
- DR3: Third driven roller
- DR4: Fourth driven roller
- DR5: Fifth driven roller
- DR6: Sixth driven roller
- DR7: Seventh driven roller
- DR8: Eighth driven roller
- DR9: Ninth driven roller
- DR10: Tenth driven roller
- DR11: Eleventh driven roller
- F: Ring frame
- F1: First ring frame
- F2: Second ring frame
- GD: Guide
- HT: Heater
- LS: Separation line
- MD: Mounter device
- MF: Mounting frame
- MF1: First mounting frame
- MF2: Second mounting frame
- MG: Magazine
- MT: Tape application mechanism
- MT1: Wafer holder
- MT2: Ring frame holder
- MT3: Positioning unit
- MT4: Elevation driver
- MT5: Attaching roller
- MT6: Separating roller
- MT7: Tape supply roller
- MT8: Tape collection roller
- MT9: Protective tape collection roller
- MT10: Tape holder
- MT11: Cutter elevation driver
- MT12: Elevating frame
- MT13: Cutter rotation driver
- MT14: Rotary frame part
- MT15: Cutter assembly
- MT16: Cutter blade
- MTX: Rotation axis
- NMD: Normal mounter device
- PF: Peeling force
- PT: Peeling tape
- RB: Robot
- RB1: First robot
- RB2: Second robot
- RB3: Third robot
- RH: Robot hand
- RM: Tape removal mechanism
- RM1: Removal head
- RM2: Peeling tape
- RM5: Heat seal
- RM6: Removal wedge
- RM7: Positioning unit
- RMD: Reversal mounter device
- RV: Reversal mechanism
- RX: Rotation axis
- SC: Adsorption pad
- T: Adhesive tape
- T1: First adhesive tape
- T1C: Outer surplus portion
- T1M: Inner circular portion
- T2: Second adhesive tape
- T2C: Outer surplus portion
- T2M: Inner circular portion
- TBL1: First table
- TBL2: Second table
- TBL3: Third table
- W: Wafer
- WP: Welded portion
- WX: Central axis
- α: Peeling angle

## Claims

1. A mounter device for applying an adhesive tape to a ring frame and a substrate, or for separating the ring frame and the substrate, both the ring frame and the substrate being adhered to the adhesive tape, the mounter device comprising:
a tape removal mechanism configured to peel the adhesive tape applied to the substrate, wherein
the tape removal mechanism is configured to cause a peeling angle to differ between a time when peeling starts and a time when peeling ends.

2. The mounter device according to claim 1,
wherein
the tape removal mechanism includes
a heating device configured to heat a peeling tape while pressing the peeling tape against the adhesive tape so as to bring the peeling tape into contact with the adhesive tape; and
a collection mechanism configured to collect the peeling tape,
the peeling tape is heated by the heating device and welded to the adhesive tape, and
the adhesive tape is peeled from the substrate by being pulled by the peeling tape collected by the collection mechanism.

3. A tape removal device for removing an adhesive tape applied to a substrate, wherein
the tape removal device is configured to cause a peeling angle to differ between a time when peeling starts and a time when peeling ends.

4. A substrate transfer apparatus for transferring a substrate on which a first adhesive tape is applied to a holding surface side to a second adhesive tape, the substrate transfer apparatus comprising:
a tape application mechanism configured to apply the second adhesive tape to a ring frame and a non-holding surface side of the substrate;
a tape cutter configured to cut the second adhesive tape along an outer shape of the ring frame;
a reversal mechanism configured to reverse the substrate adhered and held in the ring frame via the second adhesive tape; and
a tape removal mechanism configured to peel the first adhesive tape from the substrate, wherein
the tape removal mechanism is configured to cause a peeling angle to differ between a time when peeling starts and a time when peeling ends.

5. A tape removal method for removing an adhesive tape applied to a substrate, the tape removal method comprising:
applying a peeling tape to the adhesive tape; and
removing the adhesive tape to which the peeling tape is adhered from the substrate by collecting the peeling tape, wherein
in the removing the adhesive tape, the adhesive tape is peeled from the substrate in such a manner that a peeling angle is caused to differ between a time when peeling starts and a time when the peeling ends.

6. The tape removal method according to claim 5, wherein
in the applying, the peeling tape is heated and welded to the adhesive tape, with the peeling tape being pressed against the adhesive tape.

7. A substrate transfer method for transferring a substrate to which a first adhesive tape is applied on a holding surface side to a second adhesive tape, the substrate transfer method comprising:
applying the second adhesive tape to a ring frame and a non-holding surface side of the substrate;
cutting the second adhesive tape along an outer shape of the ring frame;
reversing the substrate adhered and held in the ring frame via the second adhesive tape; and
removing the first adhesive tape, wherein
in the removing the first adhesive tape, the adhesive tape is peeled from the substrate in such a manner that a peeling angle is caused to differ between a time when peeling starts and a time when the peeling ends.
